# EUROPÄISCHE PATENTSCHRIFT

(11) **EP 4 004 978 B1**
(45) Veröffentlichungstag und Bekanntmachung des Hinweises auf die Patenterteilung: **15.05.2024**
(21) Anmeldenummer: 20750192.5
(22) Anmeldetag: 23.07.2020
(51) Int. Cl.: H01L 23/495, H05K 3/32

(54) **ELEKTRISCHES UND/ODER ELEKTRONISCHES BAUELEMENT UND KONTAKTANORDNUNG**
ELECTRICAL AND/OR ELECTRONIC COMPONENT AND CONTACT ARRANGEMENT
COMPOSANT ÉLECTRIQUE ET/OU ÉLECTRONIQUE ET AGENCEMENT DE CONTACTS

(30) Priorität: 25.07.2019 DE 102019211077
(43) Veröffentlichungstag der Anmeldung: 01.06.2022
(73) Patentinhaber: Robert Bosch GmbH, 70442 Stuttgart (DE)
(72) Erfinder: HEMMERT, Reiner, 72766 Reutlingen (DE); SUENNER, Thomas, 67435 Neustadt (DE); SCHIELE, Christian, 1103 Budapest (HU)
(86) Internationale Anmeldenummer: PCT/EP2020/070758
(87) Internationale Veröffentlichungsnummer: WO 2021/013915

(56) Entgegenhaltungen:
- WO-A1-00/55925
- DE-A1-102007 006 601
- DE-A1-102007 012 501

## Beschreibung

Die Erfindung betrifft ein elektrisches und/oder elektronisches Bauelement, eine Kontaktanordnung umfassend das elektrische und/oder elektronische Bauelement sowie ein Verfahren zur Ausbildung der Kontaktanordnung gemäß dem Oberbegriff der unabhängigen Ansprüche.

### Stand der Technik

Es ist allgemein bekannt eine mechanische und elektrische Verbindung von metallischen Werkstücken mittels Schweißen, beispielsweise mittels eines Laserschweißens, herzustellen. Dies kommt u.a. zum Einsatz beispielsweise beim Verschweißen von Leistungskontakten von Leistungsmodulen innerhalb von elektronischen Leistungsschaltungen. Dabei müssen die beiden Schweißpartner - beispielsweise der Leistungskontakt und ein Anschlusspunkt der elektronischen Schaltung - sehr nahe zusammengebracht werden, in der Regel unterhalb von 100µm Spaltbreite. Bei größeren Spaltabständen kann es ansonsten zu metallischen Auswürfen beim Laserschweißen bis hin zu nicht geschweißten Kontakten kommen. Hinzukommt, dass gerade nicht oder schlecht geschweißte Kontakt optisch kaum zu erkennen sind und diese somit eine Fehlerquelle für Fehlfunktionen darstellen können. Ein idealer Nullspalt zwischen den Schweißpartnern kann technisch einfach erreicht werden, indem beide Schweißpartner mittels einer zangenartigen Vorrichtung unter elastischer und/oder plastischer Verformung bis auf einen spaltfreien Anlagenkontakt zusammengedrückt werden. Gerade bei sehr kompakten elektronischen Schaltungen ist ein erforderlicher Platz für eine derartige Vorrichtung nicht immer vorhanden. Ferner ist die Handhabung einer solchen Vorrichtung oft schwierig, da ein Zugang von beiden Seiten der Schweißpartner erfolgen muss. Zusätzlich ist in der Regel ein Gegenlager für die Schweißvorrichtung erforderlich, wofür eine Auflagefläche - beispielsweise auf dem Trägersubstrat der elektronischen Schaltung - bereitgestellt werden muss.

DE102007006601 offenbart die elektrische und mechanische Verbindung einer Kontaktanordnung mittels eines Laserstrahls.

### Offenbarung der Erfindung

### Vorteile

Der Erfindung liegt die Aufgabe zu Grunde, Schweißkontakte von elektrischen und/oder elektronischen Bauelementen innerhalb von kompakten Schaltungen möglichst spaltfrei auszubilden.

Diese Aufgabe wird durch ein elektrisches und/oder elektronisches Bauelement, eine Kontaktanordnung umfassend das elektrische und/oder elektronische Bauelement sowie ein Verfahren zur Ausbildung der Kontaktanordnung gemäß den unabhängigen Ansprüchen gelöst.

Ausgegangen wird von einem elektrischen und/oder elektronischen Bauelement mit zumindest einem elektrischen Außenanschlusskontakt. Dieser ist als eine einseitig angebundene Anschlussfahne zur elektrischen Kontaktierung mit einem Kontaktierungspartner ausgebildet. Die Anschlussfahne weist dabei für die elektrische Kontaktierung eine Verbindungsseite mit einer ebenen Verbindungsfläche auf. Sie entspricht daher im mechanischen Modellbild einem einseitig eingespannten Biegebalken. Bevorzugt ist die Anschlussfahne aus einem Blechmaterial, insbesondere als Stanzblech oder Laserblech, ausgebildet, beispielsweise aus Kupfer, und kontaktiert einen elektrischen Funktionsbereich des Bauelementes. Als ein von extern kontaktierter Außenanschlusskontakt ermöglicht dieser das Einbinden des elektrischen Funktionsbereiches beispielsweise innerhalb einer elektronischen Schaltung. Das freiliegende Ende der Anschlussfahne weist einen Biegeschenkel auf, welcher zur Verbindungsseite hin um einen Kompensationswinkel aus der Ebene gebogen ist. Der Biegeschenkel weist dabei die Verbindungsfläche auf. Ferner ist die Anschlussfahne derart nachgiebig ausgebildet, dass bei einem von der Verbindungsseite her Kraft beaufschlagten Anlagenkontakt eines zumindest in diesem Bereich ebenen Kontaktierungspartners auf das freie Ende des Biegeschenkels eine Lageorientierung der Verbindungsfläche zumindest entgegen des Kompensationswinkels bis zu einer spaltfreien Anlage der Verbindungsfläche an den ebenen Kontaktierungspartner anpassbar ist. Somit ist die Anschlussfahne in Hinblick auf einen auszubildenden Schweißkontakt vorteilhaft vorausgehend als optimierter Schweißpartner präpariert. Denn durch die Orientierung des Biegeschenkels auf der Verbindungsseite entgegen einer von dieser Seite einwirkenden Kraftbeaufschlagung, beispielsweise mittels einer zumindest mittelbbar aufliegenden Schweißmaske, ist ein Erstanlagekontakt eines von der Verbindungsseite auf die Anschlussfahne relativ zubewegten ebenen Kontaktierungspartners, beispielsweise ein Verbindungsclip, im Bereich des freien Endes der Anschlussfahne, d.h. des Biegeschenkels ermöglicht. Hierbei kann bei dem Erstanlagenkontakt zwischen der Anschlussfahne und dem Kontaktierungspartner zuerst ein Spalt ausgebildet sein, welcher keilförmig bis zum Erstanlagekontaktpunkt zuläuft. Dieser Spalt lässt sich nun bis zu einer spaltfreien Anlage reduzieren, indem eine erzwungene Verbiegung der Anschlussfahne mittels einer weiteren Kraftbeaufschlagung erwirkt wird, beispielsweise durch eine weitere Relativbewegung der genannten Schweißmaske, bevorzugt einer geradlinigen Relativbewegung. Durch die fortlaufende Verbiegung der Anschlussfahne dreht sich die Flächenlage der Verbindungsfläche entgegen des Kompensationswinkels zur Ebene des Kontaktierungspartners hin bis zur ebenflächigen und somit spaltfreien Anlage.

Dies entspricht dann einer optimalen Schweißlage, in welcher mittels eines Schweißprozesses ein spaltfreier Schweißkontakt ausbildbar ist. Der vorgesehene Kompensationswinkel ermöglicht daher die gesicherte erforderliche Lagekorrektur der Verbindungsfläche und kompensiert Fehlstellungen, beispielsweise durch Montage- und/oder Fertigungstoleranzen. Da nur eine einseitige Kraftbeaufschlagung von der Verbindungsseite her erforderlich ist, ist die Ausbildung eines Schweißkontaktes innerhalb einer sehr beengten elektronischen Schaltung ohne ein ansonsten erforderliches Gegenlager ermöglicht.

Durch die in den abhängigen Ansprüchen aufgeführten Maßnahmen sind vorteilhafte Weiterbildungen und Verbesserungen der erfindungsgemäßen elektronischen Baugruppe möglich.

In einer vorteilhaften Ausführungsform des elektrischen und/oder elektronischen Bauelementes weist der Kompensationswinkel einen Wert in einem Bereich von 0,5° bis 5° auf, bevorzugt in einem Bereich von 0,5° bis 1,5°. Es hat sich gezeigt, dass in diesem Bereich bereits viele toleranzbehaftete Ausgangsfehlstellungen durch die ermöglichte Lagekorrektur der Verbindungsfläche kompensiert werden können und die Fertigungszeiten zur Ausbildung eines Spalts freien Schweißkontaktes aufgrund von dann kurz gehaltenen Wegen bis zur Erreichung der optimalen Schweißlage klein gehalten werden können. Bevorzugt erfolgt die Erreichung der optimalen Schweißlage durch eine vollelastische Nachgiebigkeit der Anschlussfahne, zumindest jedoch alternativ bevorzugt durch eine teilelastische Nachgiebigkeit der Anschlussfahne. Auf diese Weise können auch die Beaufschlagungskräfte für die Lagekorrektur der Verbindungsfläche klein gehalten werden, so dass Beschädigungen während der Ausbildung eines Schweißkontaktes auszuschließen sind.

In einer vorteilhaften Weiterbildung des elektrischen und/oder elektronischen Bauelementes weist die Anschlussfahne einen Anschlussschenkel auf. Dieser mündet mit seinem einen Ende über einen Biegebereich in den Biegeschenkel und umfasst an seinem anderen Ende dann die einseitige Anbindung der Anschlussfahne innerhalb des elektrischen und/oder elektronischen Bauelementes. Vorteilhaft weist die Anschlussfahne nur eine Biegestelle auf, so dass die Präparierung der Anschlussfahne sich für einen optimal auszubildenden Schweißkontakt sehr kostengünstig umsetzen lässt. Hierbei kann die Biegung vorzugsweise in eine ursprüngliche Anschlussfahne aus einem ebenen Blechmaterial eingebracht sein, so dass insbesondere ein sich geradlinig erstreckender Anschlussschenkel verbleibt. Allgemein vorteilhaft ist eine Längserstreckung des Anschlussschenkels um ein Vielfaches kürzer als eine Längserstreckung des Biegeschenkels, insbesondere um das 2 bis 20-fache kürzer, bevorzugt um das 5 bis 10-fache kürzer. Auf diese Weise ergibt sich zunehmend eine Nachgiebigkeit der Anschlussfahne mehr oder weniger allein durch den Biegeschenkel. Dabei stellt die Biegestelle dann angenähert die Funktion eines starren Drehgelenks. Ferner lässt sich die optimale Schweißposition genauer einstellen.

In einer bevorzugten Ausführungsform des elektrischen und/oder elektronischen Bauelements weist dieses ein festes Gehäuse auf, aus welchem die Anschlussfahne einseitig angebunden hervorsteht. Das Gehäuse ist bevorzugt aus einem Kunststoff, insbesondere einem Moldmaterial, gebildet. Dabei ist weiter bevorzugt die Anschlussfahne an ihrem angebundenen Ende von dem Kunststoff allseitig umschlossen bzw. umhüllt. Mittels des Gehäuses können dann vorteilhaft erhöhte Beaufschlagungskräfte auf die Anschlussfahne schadensfrei von dem elektrischen und/oder elektronischen Bauelement aufgenommen werden.

Weitere Vorteile zeigen sich in einer Ausführungsform des elektrischen und/oder elektronischen Bauelementes, welches eine beispielsweise unterseitige Anschluss- und/oder Auflageseite zu einem Trägersubstrat aufweist. Dabei ist die Anschlussfahne zur unterseitigen Anschluss- und/oder Auflageseite hin beabstandet angeordnet. Ferner ist in einer Draufsicht auf die Anschluss- oder Auflageseite die Anschlussfahne zu dieser seitlich abstehend innerhalb des elektrischen und/oder elektronischen Bauelements einseitig angebunden. Der Biegeschenkel zeigt dabei von der Anschluss- und/oder Auflageseite weg. Damit ist insgesamt ein freier Zugang zu den Anschlussfahnen für eine einseitige Kraftbeaufschlagung von der Verbindungsseite her gegeben. Außerdem ist durch die Beabstandung eine ungehinderte Verbiegung der Anschlussfahne in Richtung der Anschluss- oder Auflageseite ermöglicht. Bevorzugt weist ein gehäustes elektrisches und/oder elektronisches Bauelement eine Austrittsstelle eines Anschlussschenkels der Anschlussfahne aus dem Gehäuse in einer zur Anschluss- oder Auflageseite parallelen Anschlussebene auf. Weiter bevorzugt liegt der Anschlussschenkel bis zur Biegestelle innerhalb dieser Anschlussebene, wogegen der Biegeschenkel insbesondere senkrecht zu einer Längserstreckung des Anschlussschenkels aus der Anschlussebene in Richtung der Verbindungsseite der Anschlussfahne gebogen ist.

Allgemein bevorzugt ist das elektrische und/oder elektronische Bauelement als ein Leistungsmodul ausgebildet, insbesondere in Form eines Moldmodules.

Dabei ist die Anschlussfahne als Leistungskontakt ausgebildet. Das elektrische und/oder elektronische Bauelement kann insgesamt auch zwei, drei oder noch mehr derartige Anschlussfahnen ausschließlich oder neben zumindest einem andersartig ausgebildeten Außenanschlusskontakt aufweisen.

Die Erfindung führt auch zu einer Kontaktanordnung, umfassend zumindest ein elektrisches und/oder elektronisches Bauelement in zumindest einer der zuvor beschriebenen Ausführungsformen, wobei zwischen der Anschlussfahne im Bereich der Verbindungsfläche und einem - zumindest in dem ausgebildeten Verbindungsbereich - ebenen Kontaktierungspartner ein insbesondere spaltfreier Verbindungskontakt ausgebildet ist. Ein solcher Verbindungskontakt stellt eine über Lebensdauer funktionssichere Verbindung beispielsweise zu einer elektronischen Schaltung dar. Der Verbindungskontakt ist dabei insbesondere als ein Schweißkontakt ausgebildet. Bei der Anwendung eines Laserprozesses ergibt sich dabei insbesondere ein Laserschweißkontakt.

In einer bevorzugten Ausführungsform der Kontaktanordnung ist diese als Teil einer elektronischen Schaltung auf einem Trägersubstrat ausgebildet. Der Kontaktierungspartner ist insbesondere ein Verbindungsclip, welcher die Anschlussfahne und einen Anschlusspunkt der elektronischen Schaltung überbrückend miteinander verbindet. Der Verbindungsclip ist dabei beispielweise ein Stanzblechteil, insbesondere aus Kupfer. Neben ebenen Flächen in den Verbindungsbereichen zur Anschlussfahne bzw. zum Anschlusspunkt kann der Verbindungsclip ein oder mehrere Biegungen aufweisen, beispielsweise um einen anwendungsbedingten Höhenversatz zwischen der Anschlussfahne und dem Verbindungspunkt der elektronischen Schaltung zu überspannen. Ferner kann der Verbindungsclip Aussparungen, insbesondere in Form von Längsschlitzen zwischen den Verbindungsstellen, aufweisen. Auf diese Weise erhält der Verbindungsclip eine ausreichende mechanische Elastizität, um eine Ausrichtung der vorgesehenen Fügeflächen in den Verbindungsbereichen durch ein Verbiegen und/oder Tordieren bis zu einer spaltfreien Anlage zum jeweiligen Schweißpartner zu ermöglichen.

Bevorzugt ist die elektronische Schaltung als B2- oder B6-Brücke ausgebildet, insbesondere als Schaltungsteil eines Inverters.

Die Erfindung führt auch zu einem Verfahren zur Ausbildung einer Kontaktanordnung nach zumindest einer der zuvor beschriebenen Ausführungsformen, mit den nachfolgenden Verfahrensschritten:
a) Bereitstellen eines elektrischen und/oder elektronischen Bauelementes nach zumindest einer der zuvor beschriebenen Ausführungsformen, beispielsweise indem dieses über seine beispielsweise unterseitige Anschluss- und/oder Auflageseite auf einem Trägersubstrat angeordnet wird,
b) Ausbildung einer Ausgangsanordnung, indem eine ebene Auflageseite eines Kontaktierungspartners von der Verbindungsseite der Anschlussfahne her in Anlagenkontakt mit dem freiliegenden Ende des Biegeschenkels angeordnet wird und eine Schweißmaske auf einer der Auflageseite des Kontaktierungspartners gegenüberliegenden Schweißseite aufgelegt wird,
c) Kraftbeaufschlagung der Ausgangsanordnung durch eine Niederdrückkraft, insbesondere mittels einer bevorzugt geradlinigen Relativbewegung der Schweißmaske, derart, dass durch ein Nachgeben der Anschlussfahne in Kraftrichtung eine geänderte Lageorientierung der Verbindungsfläche zumindest entgegen des Kompensationswinkels des Biegeschenkels erfolgt,
d) Festhalten einer Schweißposition, bei welcher die Verbindungsfläche der Anschlussfahne und die Auflageseite des Kontaktierungspartners ebenflächig aneinander liegen,
e) Ausbildung eines Schweißkontaktes, beispielsweise mittels Lasern auf der Schweißseite des Kontaktierungspartners, als spaltfreier Verbindungskontakt zwischen der Anschlussfahne und dem Kontaktierungspartner.

Bei einer vorteilhaften Ausführungsform des Verfahrens ist der Kontaktierungspartner als Verbindungsclip ausgebildet, wobei vor oder während des Verfahrensschrittes b) ein zum Anlagenkontakt beabstandetes Ende des Verbindungsclips ortsfest gehalten wird. Dies kann beispielsweise mittels eines Haltewerkzeugs erfolgen, welches das besagte Ende aufnimmt und ortsfest fixiert. Alternativ erfolgt eine ortsfeste Fixierung durch eine zumindest mittelbare stoff- oder kraft- und/oder formschlüssigen Verbindung mit dem Trägersubstrat. Durch das einseitige Fixieren können sich die Anschlussfahne und der Verbindungsclip allein durch die Kraftbeaufschlagung und Verbiegung bis zu einer spaltfreien Anlage im Verbindungsbereich zueinander ausrichten.

In einer vorteilhaften Weiterbildung des Verfahrens wird zwischen dem ortsfest gehaltenen Ende des Verbindungsclips und dem auszubildenden bzw. ausgebildeten Verbindungskontakt mit der Anschlussfahne ein weiterer Verbindungskontakt zwischen dem Verbindungsclip und einem Anschlusspunkt einer elektronischen Schaltung ausgebildet, insbesondere als Schweißkontakt. Die Ausbildung des weiteren Verbindungskontakts erfolgt dabei zeitlich vor, nach oder zusammen mit dem Verbindungskontakt zwischen dem Verbindungsclip und der Anschlussfahne.

### Kurze Beschreibung der Zeichnungen

Weitere Vorteile, Merkmale und Einzelheiten der Erfindung ergeben sich aus der nachfolgenden Beschreibung bevorzugter Ausführungsbeispiele sowie anhand der Zeichnung. Diese zeigt in:
- Fig. 1:: ein elektrisches und/oder elektronisches Bauelement mit einem endseitigen Biegeschenkel innerhalb einer einseitig angebundenen Anschlussfahne als Außenkontaktanschluss in einer Seitenansicht,
- Fig. 2:: eine Ausgangsanordnung umfassend ein elektrisches und/oder elektronisches Bauelement aus Fig. 1 in einer Erstkontaktanlage mit einem Kontaktierungspartner mit einem Erstkontaktanlagepunkt am freiliegenden Ende des Biegeschenkels der Anschlussfahne in einer Seitenansicht,
- Fig. 3:: eine aus der Ausgangsanordnung nach Fig. 2 hervorgegangene Kontaktanordnung nach einer Kraftbeaufschlagung und Verschweißung unter Ausbildung eines Spalts freien Schweißkontaktes zwischen der Anschlussfahne und dem Kontaktierungspartner in einer Seitenansicht,
- Fig. 4:: eine Kontaktanordnung innerhalb einer elektronischen Schaltung, insbesondere einer Inverterschaltung, in einer perspektivischen Darstellung.

### Ausführungsformen der Erfindung

In den Figuren sind funktional gleiche Bauelemente jeweils mit gleichen Bezugszeichen gekennzeichnet.

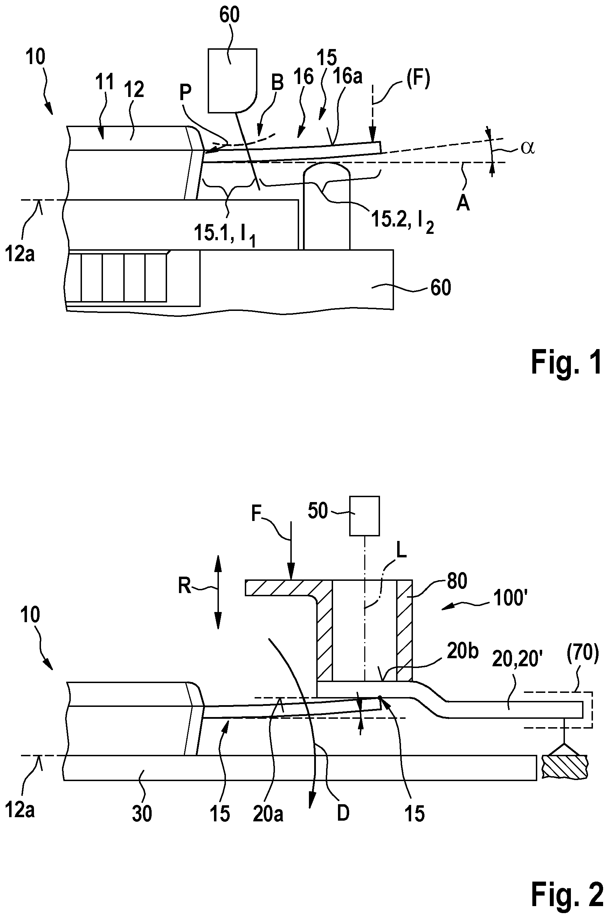

Die Fig. 1 zeigt in einer Seitenansicht ein elektrisches und/oder elektronisches Bauelements 10. Dieses weist einen Außenkontaktanschluss 15 auf, welcher als eine einseitig angebundene Anschlussfahne ausgebildet ist. Die Anbindung erfolgt an eine Bauelementgrundkörper 11, über welchen die Anschlussfahne 15 mit einem elektrischen Funktionsbereich des Bauelementes 10 kontaktiert ist. Die Anschlussfahne 15 ist beispielhaft aus einem Blechmaterial gebildet, beispielsweise aus einem Kupferblech. Die Anschlussfahne 15 weist im vorliegenden Ausführungsbeispiel eine Biegestelle B auf und unterteilt damit über die Längserstreckung der Anschlussfahne 15 diese abschnittsweise zumindest in einen Längsabschnitt I1 eines Anschlussschenkels 15.1 und in einen anschließenden Längsabschnitt I2 eines Biegeschenkels 15.2. Der Anschlussschenkel 15.1 ist damit mit seinem einen Ende einseitig an den Bauelementgrundkörper 11 angebunden und mündet über das andere Ende ab der Biegestelle B in das eine Ende des Biegeschenkels 15.2. Das andere Ende des Biegeschenkels 15.2 ist freiliegend. Der Biegeschenkel 15.2 ist dabei um einen Kompensationswinkel α aus einer Anschlusseben A gebogen, in welcher beispielsweise vor der Biegung eine einheitliche Oberflächenseite der noch ungebogenen Anschlussfahne 15 angeordnet war. Die Biegung erfolgt dabei zu einer Verbindungsseite 16 der Anschlussfahne 15 hin. Über die Verbindungsseite 16 erfolgt später mittels eines Verbindungskontaktes eine elektrische Verbindung der Anschlussfahne 15 als Außenanschlusskontakt an einen Kontaktierungspartner. Hierzu umfasst der Biegeschenkel 15.2 eine Verbindungsfläche 16a über welche der Verbindungskontakt dann ausbildbar ist. Bevorzugt ist der Anschlussschenkel 15.1 mit seiner einen Oberflächenseite in der Anschlussebene A angeordnet. Weiter bevorzugt weist das elektrische und/oder elektronische Bauelement 10 ein Gehäuse 12 auf, insbesondere aus Kunststoff. Das Gehäuse 12 ist dann beispielsweise aus einem Moldmaterial gebildet. Dabei weist das elektrische und/oder elektronische Bauelement 10 auch eine unterseitige Anschluss- oder Auflageseite 12a auf, über welche das Bauelement 10 auf einem Trägersubstrat 30 angeordnet werden kann. Die Anschlussfahne 15 tritt dabei im Bereich des Anschlussschenkels 15.1 in einem Austrittspunkt P aus dem Gehäuse 12 hervor. Der Austrittspunkt P befindet sich insbesondere in der Anschlussebene A, so dass der Austrittspunkt P und die Anschlussebene in einer parallelen Beabstandung zur unterseitigen Anschluss- oder Auflageseite 12a angeordnet sind. Insgesamt zeigt sich die Anschlussfahne 15 modellhaft als ein einseitig eingespannter Biegebalken. Bei einer Krafteinwirkung mit einer Kraft F von der Verbindungsseite 16a her, beispielsweise auf das freiliegende Ende des Biegeschenkels 15.2, erfolgt eine bevorzugt vollelastische oder zumindest teilelastische Verbiegung in Richtung der unterseitigen Anschluss- oder Auflageseite 12a des Bauelementes 10. Hierbei ändert sich auch eine Lageorientierung der Verbindungsfläche 16a zumindest entgegen des Kompensationswinkels α. Bevorzugt ist dabei der Längsabschnitt I1 des Anschlussschenkels 15.1 um ein Vielfaches kürzer ausgebildet als der Längsabschnitt I2 des Biegeschenkels 15.2, insbesondere um das 2 bis 20-fache kürzer, bevorzugt um das 5 bis 10-fache kürzer. Hierdurch ergibt sich bei der Krafteinwirkung zunehmend eine Drehbewegung um die Biegestelle B als dann im Wesentlichen starres Drehgelenk. Die Biegestelle B wird beispielsweise durch ein Biegewerkzeug 60 in eine noch ungebogene Anschlussfahne 15 eingebracht. Das Werkzeug 60 umfasst dabei beispielsweise einen festen Anschlag und einen verfahrbaren Biegestift, wobei der Biegestift durch eine Kraftbewegung in Kontakt mit der Anschlussfahne 15 diese gegen den festen Anschlag in der Biegestelle B zur Verbindungsseite 16 hin verbiegt.

In der Seitenansicht der Fig. 1 ist nur eine Anschlussfahne in der beschriebenen Ausführung sichtbar. Grundsätzlich kann das elektrische und/oder elektronische Bauelement 10 noch weitere gleiche oder gleichartige Anschlussfahnen 15 ausschließlich oder neben zumindest einem anders ausgeführten Außenanschlusskontakt umfassen.

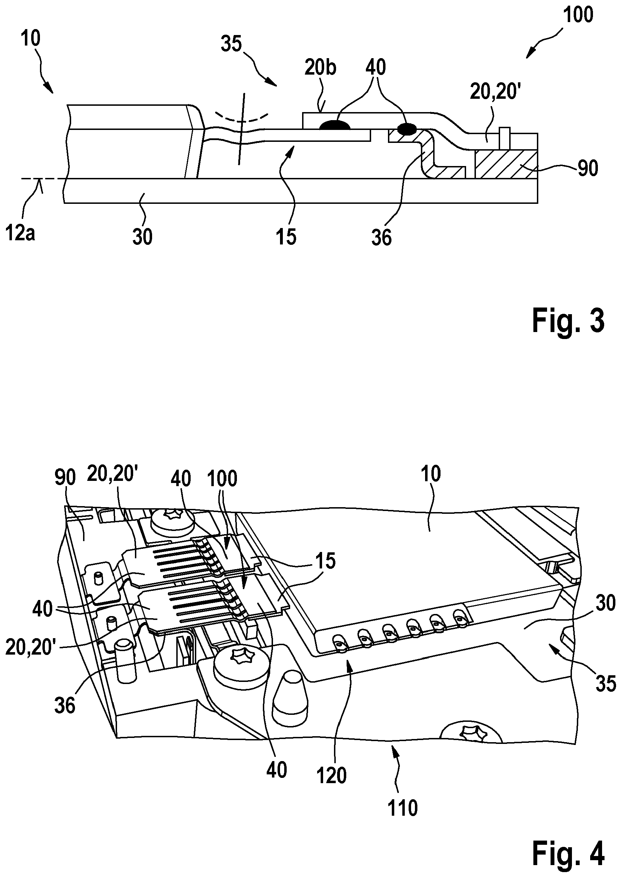

Zur Ausbildung einer Kontaktanordnung 100 umfassend das elektrische und/oder elektronische Bauelement 10 mit einem Verbindungskontakt 40 zu einem Kontaktierungspartner 20 kann - wie nachfolgend mit Hilfe der Fig. 2 und 3 beschrieben - verfahren werden. Zuerst wird das elektrische und/oder elektronische Bauelement 10 für einen Verbindungsprozess bereitgestellt. Hierfür wird es beispielsweise über seine unterseitige Anschluss- oder Verbindungsseite 12a auf einem Trägersubstrat 30 angeordnet, beispielsweise mittels eines Sinter- oder Lotkontakts. Als Trägersubstrat 30 können unterschiedlichste Substrattypen genutzt werden, beispielsweise ein Leadframe, eine starre oder flexible Leiterplatte, ein DBC-Substrat (double bonded copper), ein IMS-Substrat (insulated metal substrat), ein AMB-Substrat (active metal brazing) ein LTCC-Substrat (low temperature cofired ceramic) oder andere. Nachfolgend wird eine Ausgangsanordnung 100' ausgebildet. Dabei wird ein ebener Bereich einer Auflageseite 20a eines zu verbindenden Kontaktierungspartners 20 in einen Erstanlagekontakt mit dem freien Ende des Biegeschenkels 15.2 gebracht.

Der Kontaktierungspartner 20 kann beispielsweise durch einen Bestückprozess von der Verbindungsseite 16 der Anschlussfahne 15 her kommend in einer Position angeordnet werden, in welcher die Auflageseite 20a des Kontaktierungspunktes das Ende des Biegeschenkels in einem Erstanlagepunkt E berührt. In dieser Position wird der Kontaktierungspartner 20 an einem zum Erstanlagepunkt E beabstandenden Ende des Kontaktierungspartners 20 ortsfest gehalten, beispielsweise durch ein Haltewerkzeug 70 oder durch eine stoff- oder form- und/oder kraftschlüssige Verbindung, beispielsweise mit dem Trägersubstrat 30. Zeitgleich mit dem Bestückprozess oder alternativ anschließend wird eine Schweißmaske 80 auf eine der Auflageseite 20a gegenüberliegende Schweißseite 20b des Kontaktierungspartners 20 aufgelegt. Ebenso kann ein Erstanlagekontakt ausgebildet werden, nachdem zuvor auf die Schweißseite 20b eines einseitig ortsfest gehaltenen Kontaktierungspartners 20 die Schweißmaske 80 aufgelegt wurde und diese in Richtung der Verbindungsseite 16 der Anschlussfahne 15 bis zum Erreichen der Erstanlagepunktes E verfahren wird.

Grundsätzlich wird nach Vorliegen eines Erstanlagepunktes E durch eine weitere beispielsweise geradlinige Relativbewegung R der Schweißmaske 20 in Richtung der Verbindungsseite 16 der Anschlussfahne 15 die Ausgangsanordnung 100' kraftbeaufschlagt. Durch die einwirkende Niederdrückkraft F gibt die Anschlussfahne 15 in Richtung Trägersubstrat 20 elastisch oder zumindest teilelastisch durch eine zumindest anteilige Drehbewegung D nach, wodurch auch eine geänderte Lageorientierung der Verbindungsfläche 16a zumindest entgegen des Kompensationswinkels α des Biegeschenkels 15.2 erfolgt. Die Relativbewegung R der Schweißmaske 80 wird erst in einer Schweißposition festgehalten, bei welcher die Verbindungsfläche 16a der Anschlussfahne 15 und die Auflageseite 20a des Kontaktierungspartners 20 ebenflächig aneinander liegen. Daraufhin wird mit Hilfe eines Schweißprozesses unter Beibehaltung der Schweißposition ein Schweißkontakt 40 als Verbindungskontakt ausgebildet. Der Schweißprozess erfolgt beispielsweise mittels eines Lasers 50, dessen Laserstrahlung L auf die Schweißseite 20b des Kontaktierungspartners 20 gerichtet ist. Die Schweißmaske 80 ist bevorzugt rohrartig gestaltet und weist dabei insbesondere eine Wandungshöhe auf, durch welche metallischen Auswürfen beim Laserschweißen an einer Streuung außerhalb der Schweißmaske 80 gehindert werden.

In der Fig. 3 ist die ausgebildete Kontaktanordnung 100 mit dem dann spaltfreien Schweißkontakt 40 zwischen der Anschlussfahne 15 und dem Kontaktierungspartner 20 in einer Seitenansicht nach dem Entfernen der Schweißmaske 80 gezeigt. Der Kontaktierungspartner 20 ist dann beispielsweise ein Verbindungsclips 20`, welcher insbesondere als ein Stanzblechteil ausgebildet, bevorzugt aus Kupfer. Im Gegensatz zur Darstellung in der Fig. 2 ist das dem Schweißkontakt 40 beabstandete Ende des Verbindungsclips 20' mittelbar über ein Rahmenelement 90 kraft- und/oder formschlüssig mit dem Trägersubstrat 30 verbunden und somit ortsfest gehalten, beispielsweise über eine Loch-Stiftverbindung. Zusätzlich ist zwischen dem ortsfest gehaltenen Ende des Verbindungsclips 20' und dem ausgebildeten Schweißkontakt 40 mit der Anschlussfahne15 ein weiterer Schweißkontakt 40 als Verbindungskontakt zwischen dem Verbindungsclip 20' und einem Anschlusspunkt 36 einer auf dem Trägersubstrat 30 angeordneten elektronischen Schaltung 35 ausgebildet ist. Der weitere Verbindungskontakt 40 kann dabei zeitlich vor, nach oder zusammen mit dem Verbindungskontakt zwischen dem Verbindungsclip 20' und der Anschlussfahne 15 mittels dem Laser 50 ausgebildet werden.

In der Fig. 4 ist die Kontaktanordnung aus der Fig. 3 in einer perspektivischen Darstellung beispielsweise als Schaltungsteil eines Inverters 110 gezeigt. Die elektronische Schaltung 35 umfasst hierbei eine B2- oder eine B6-Brücke, welche durch zumindest ein beschriebenes elektrisches und/oder elektronisches Bauteil 10 gebildet ist, insbesondere als ein Leistungsmodul, bevorzugt in Form eines Moldmodules. Im vorliegenden Ausführungsbeispiel sind zwei auf der gleichen Seite angeordnete Leistungskontakte 15 unter Ausbildung der Kontaktanordnung 100 jeweils mit einem Verbindungsclip 20' mittels eines Spalts freien Schweißkontaktes 40 verbunden.

## Patentansprüche

1. Elektrisches und/oder elektronisches Bauelement (10) mit zumindest einem elektrischen Außenanschlusskontakt (15), welcher als eine einseitig angebundene Anschlussfahne (15) zur elektrischen Kontaktierung mit einem Kontaktierungspartner (20, 20') ausgebildet ist und die Anschlussfahne (15) für die elektrische Kontaktierung eine Verbindungsseite (16) mit einer ebenen Verbindungsfläche (16a) aufweist, **dass** das freiliegende Ende der Anschlussfahne (15) einen Biegeschenkel (15.2) aufweist, welcher zur Verbindungsseite (16) hin um einen Kompensationswinkel (α) aus der Ebene (A) gebogen ist, wobei der Biegeschenkel (15.2) die Verbindungsfläche (16a) aufweist und die Anschlussfahne (15) derart nachgiebig ausgebildet ist, **dadurch gekennzeichnet, dass** bei einem von der Verbindungsseite (16) her Kraft beaufschlagten Anlagenkontakt eines ebenen Kontaktierungspartners (20, 20') auf das freie Ende des Biegeschenkels (15.2) eine Lageorientierung der Verbindungsfläche (16a) entgegen des Kompensationswinkels (α) bis zu einer spaltfreien Anlage der Verbindungsfläche (16a) an den ebenen Kontaktierungspartner (20, 20`) anpassbar ist.

2. Elektrisches und/oder elektronisches Bauelement (10) nach Anspruch 1,
**dadurch gekennzeichnet, dass**
der Kompensationswinkel (α) einen Wert in einem Bereich von 0,5° bis 5° aufweist, bevorzugt in einem Bereich von 0,5° bis 1,5°.

3. Elektrisches und/oder elektronisches Bauelement (10) nach Anspruch 1 oder 2,
**dadurch gekennzeichnet, dass**
die Anschlussfahne (15) einen Anschlussschenkel (15.1) aufweist, insbesondere einen sich geradlinig erstreckenden Anschlussschenkel (15.1), welcher mit seinem einen Ende über eine Biegestelle (B) in den Biegeschenkel (15.2) mündet und an seinem anderen Ende eine einseitige Anbindung der Anschlussfahne (15) innerhalb des elektrischen und/oder elektronischen Bauelementes (10) umfasst.

4. Elektrisches und/oder elektronisches Bauelement (10) nach Anspruch 3,
**dadurch gekennzeichnet, dass**
eine Längserstreckung des Anschlussschenkels (15.1) um ein Vielfaches kürzer ist als eine Längserstreckung des Biegeschenkels (15,2), insbesondere um das 2 bis 20-fache kürzer, bevorzugt um das 5 bis 10-fache kürzer.

5. Elektrisches und/oder elektronisches Bauelementnach (10) nach einem der vorhergehenden Ansprüche,
**dadurch gekennzeichnet, dass**
das elektrische und/oder elektronische Bauelement (10) ein Gehäuse (12) aufweist, aus welchem die Anschlussfahne (15) einseitig angebunden hervorsteht.

6. Elektrisches und/oder elektronisches Bauelement (10) nach einem der vorhergehenden Ansprüche,
**dadurch gekennzeichnet, dass**
das elektrische und/oder elektronische Bauelement (10) eine Anschluss- und/oder Auflageseite (12a) zu einem Trägersubstrat (30) aufweist, wobei die Anschlussfahne (15) zur Anschluss- und/oder Auflageseite (12a) hin beabstandet angeordnet ist und in einer Draufsicht auf die Anschluss- oder Auflageseite (12a) zu dieser seitlich abstehend innerhalb des elektrischen und/oder elektronischen Bauelements (10) einseitig angebunden ist, wobei der Biegeschenkel (15.2) von der Anschluss- und/oder Auflageseite (12a) wegzeigt.

7. Elektrisches und/oder elektronisches Bauelement (10) nach einem der vorhergehenden Ansprüche,
**dadurch gekennzeichnet, dass**
das elektrische und/oder elektronische Bauelement (10) als ein Leistungsmodul ausgebildet ist, insbesondere in Form eines Moldmodules.

8. Kontaktanordnung (100), umfassend zumindest ein elektrisches und/oder elektronisches Bauelement (10) gemäß einem der vorhergehenden Ansprüche, wobei zwischen der Anschlussfahne (15) im Bereich der Verbindungsfläche (16a) und einem ebenen Kontaktierungspartner (20, 20`) ein insbesondere Spalt freier Verbindungskontakt (40) ausgebildet ist.

9. Kontaktanordnung (100) nach Anspruch 8,
**dadurch gekennzeichnet, dass**
der Verbindungskontakt (40) als ein Schweißkontakt ausgebildet ist, insbesondere als ein Laserschweißkontakt.

10. Kontaktanordnung (100) nach einem der Ansprüche 8 oder 9,
**dadurch gekennzeichnet, dass**
die Kontaktanordnung (100) als Teil einer elektronischen Schaltung (35) auf einem Trägersubstrat (30) ausgebildet ist, wobei der Kontaktierungspartner (20, 20') ein Verbindungsclip ist, welcher die Anschlussfahne (15) und einen Anschlusspunkt (36) der elektronischen Schaltung (35) überbrückend miteinander verbindet.

11. Kontaktanordnung (100) nach Anspruch 10,
**dadurch gekennzeichnet, dass**
die elektronische Schaltung als B2- oder B6-Brücke (120) ausgebildet ist, insbesondere als Schaltungsteil eines Inverters (110).

12. Verfahren zur Ausbildung einer Kontaktanordnung (100) nach einem der Ansprüche 8 bis 11, mit den nachfolgenden Verfahrensschritten:
a) Bereitstellen eines elektrischen und/oder elektronischen Bauelementes (10) nach einem der Ansprüche 1 bis 7, beispielsweise indem dieses über seine unterseitige Anschluss- und/oder Auflageseite (12a) auf einem Trägersubstrat (30) angeordnet wird,
b) Ausbildung einer Ausgangsanordnung (100'), indem eine ebene Auflageseite (20a) eines Kontaktierungspartners (20, 20`) von der Verbindungsseite (16) der Anschlussfahne (15) her in Anlagenkontakt mit dem freiliegenden Ende des Biegeschenkels (15.2) angeordnet wird und eine Schweißmaske (80) auf einer der Auflageseite (20a) des Kontaktierungspartners (20, 20') gegenüberliegenden Schweißseite (20b) aufgelegt wird,
c) Kraftbeaufschlagung der Ausgangsanordnung (100') durch eine Niederdrückkraft (F), insbesondere mittels einer bevorzugt geradlinigen Relativbewegung (R) der Schweißmaske (80), derart, dass durch ein Nachgeben der Anschlussfahne (15) in Kraftrichtung eine geänderte Lageorientierung der Verbindungsfläche (16a) entgegen des Kompensationswinkels (α) des Biegeschenkels (15.2) erfolgt,
d) Festhalten einer Schweißposition, bei welcher die Verbindungsfläche (16a) der Anschlussfahne (15) und die Auflageseite (20a) des Kontaktierungspartners (20, 20') ebenflächig aneinander liegen,
e) Ausbildung eines Schweißkontaktes (40), beispielsweise mittels Lasern auf der Schweißseite (20b) des Kontaktierungspartners (20, 20'), als Spalt freier Verbindungskontakt (40) zwischen der Anschlussfahne (15) und dem Kontaktierungspartner (20, 20').

13. Verfahren nach Anspruch 12,
**dadurch gekennzeichnet, dass**
der Kontaktierungspartner (20) als Verbindungsclip (20') ausgebildet ist, wobei vor oder während des Verfahrensschrittes b) ein zum Anlagenkontakt beabstandetes Ende des Verbindungsclips (20') ortsfest gehalten wird, beispielsweise mittels eines Haltewerkzeugs (70) oder einer zumindest mittelbaren stoff- oder kraft- und/oder formschlüssigen Verbindung mit dem Trägersubstrat (30).

14. Verfahren nach Anspruch 13,
**dadurch gekennzeichnet, dass**
zwischen dem ortsfest gehaltenen Ende des Verbindungsclips (20') und dem auszubildenden bzw. ausgebildeten Verbindungskontakt (40) mit der Anschlussfahne (15) ein weiterer Verbindungskontakt (40) zwischen dem Verbindungsclip (20') und einem Anschlusspunkt (36) einer elektronischen Schaltung (35) ausgebildet wird, insbesondere als Schweißkontakt.

15. Verfahren nach Anspruch 14,
**dadurch gekennzeichnet, dass**
der weitere Verbindungskontakt (40) zeitlich vor, nach oder zusammen mit dem Verbindungskontakt (40) zwischen dem Verbindungsclip (20, 20`) und der Anschlussfahne (15) ausgebildet wird.

## Claims

1. Electrical and/or electronic component (10) having at least one external electrical connection contact (15) which is designed as a connection lug (15) which is attached on one side and has the purpose of making electrical contact with a contact-making partner (20, 20') and the connection lug (15) has a connecting side (16) with a planar connecting area (16a) for making electrical contacts,
in that
the exposed end of the connection lug (15) has a bending limb (15.2) which is bent out of the plane (A) towards the connecting side (16) through a compensation angle (α), wherein the bending limb (15.2) has the connecting area (16a) and the connection lug (15) is designed in a resilient manner in such a way, **characterized in that**, with bearing contact, with force applied from the connecting side (16), of a planar contact-making partner (20, 20') on the free end of the bending limb (15.2), positional orientation of the connecting area (16a) can be adjusted counter to the compensation angle (α) until gap-free bearing of the connecting area (16a) on the planar contact-making partner (20, 20') is achieved.

2. Electrical and/or electronic component (10) according to Claim 1,
**characterized in that**
the compensation angle (α) has a value in a range of from 0.5° to 5°, preferably in a range of from 0.5° to 1.5°.

3. Electrical and/or electronic component (10) according to Claim 1 or 2,
**characterized in that**
the connection lug (15) has a connection limb (15.1), in particular a connection limb (15.1) which extends in a straight line, opens, by way of one end, into the bending limb (15.2) via a bending point (B) and, at its other end, exhibits one-sided attachment of the connection lug (15) within the electrical and/or electronic component (10) .

4. Electrical and/or electronic component (10) according to Claim 3,
**characterized in that**
a longitudinal extent of the connection limb (15.1) is several times shorter than a longitudinal extent of the bending limb (15.2), in particular 2 to 20 times shorter, preferably 5 to 10 times shorter.

5. Electrical and/or electronic component (10) according to any of the preceding claims,
**characterized in that**
the electrical and/or electronic component (10) has a housing (12), the connection lug (15) projecting out of the housing in a manner attached on one side.

6. Electrical and/or electronic component (10) according to any of the preceding claims,
**characterized in that**
the electrical and/or electronic component (10) has a connection and/or support side (12a) to a carrier substrate (30), wherein the connection lug (15) is arranged at a distance from the connection and/or support side (12a) and, in a plan view of the connection or support side (12a), is attached to it on one side in a manner projecting laterally within the electrical and/or electronic component (10), wherein the bending limb (15.2) points away from the connection and/or support side (12a).

7. Electrical and/or electronic component (10) according to any of the preceding claims,
**characterized in that**
the electrical and/or electronic component (10) is designed as a power module, in particular in the form of a moulded module.

8. Contact arrangement (100), comprising at least one electrical and/or electronic component (10) according to any of the preceding claims, wherein an in particular gap-free connecting contact (40) is formed between the connection lug (15) in the region of the connecting area (16a) and a planar contact-making partner (20, 20').

9. Contact arrangement (100) according to Claim 8, **characterized in that**
the connecting contact (40) is designed as a welded contact, in particular as a laser-welded contact.

10. Contact arrangement (100) according to either of Claims 8 and 9,
**characterized in that**
the contact arrangement (100) is designed as part of an electronic circuit (35) on a carrier substrate (30), wherein the contact-making partner (20, 20') is a connecting clip which connects the connection lug (15) and a connection point (36) of the electronic circuit (35) to each other in a bridging manner.

11. Contact arrangement (100) according to Claim 10, **characterized in that**
the electronic circuit is designed as a B2 or B6 bridge (120), in particular as a circuit part of an inverter (110) .

12. Method for forming a contact arrangement (100) according to any of Claims 8 to 11, comprising the following method steps:
a) providing an electrical and/or electronic component (10) according to any of Claims 1 to 7, for example by way of the electrical and/or electronic component being arranged on a carrier substrate (30) via its bottom-side connection and/or support side (12a),
b) forming an output arrangement (100') by way of a planar support side (20a) of a contact-making partner (20, 20') being arranged in bearing contact with the exposed end of the bending limb (15.2) from the connecting side (16) of the connection lug (15) and a welding mask (80) being placed on a welding side (20b) opposite the support side (20a) of the contact-making partner (20, 20'),
c) application of force to the output arrangement (100') by a pressing-down force (F), in particular by means of a preferably rectilinear relative movement (R) of the welding mask (80) in such a way that a changed positional orientation of the connecting area (16a) counter to the compensation angle (α) of the bending limb (15.2) takes place owing to yielding of the connection lug (15) in the direction of force,
d) holding a welding position, in which the connecting area (16a) of the connection lug (15) and the support side (20a) of the contact-making partner (20, 20') lie flat against each other,
e) forming a welded contact (40), for example by means of lasers on the welding side (20b) of the contact-making partner (20, 20'), as a gap-free connecting contact (40) between the connection lug (15) and the contact-making partner (20, 20').

13. Method according to Claim 12,
**characterized in that**
the contact-making partner (20) is designed as a connecting clip (20'), wherein an end of the connecting clip (20'), which end is spaced apart from the bearing contact, is held fixed in position before or during method step (b), for example by means of a holding tool (70) or an at least indirect cohesive or force-fitting and/or form-fitting connection to the carrier substrate (30) .

14. Method according to Claim 13,
**characterized in that**
a further connecting contact (40) is formed between the connecting clip (20') and a connection point (36) of an electronic circuit (35), in particular as a welding contact, between the end of the connecting clip (20') that is held fixed in position and the connecting contact (40) which is to be formed or is formed with the connection lug (15).

15. Method according to Claim 14,
**characterized in that**
the further connecting contact (40) is formed before, after or together with the connecting contact (40) between the connecting clip (20, 20') and the connection lug (15).

## Revendications

1. Composant électrique et/ou électronique (10) ayant au moins un contact de connexion électrique externe (15), qui est conçu sous la forme d'une languette de connexion (15) reliée d'un côté pour la mise en contact électrique avec un partenaire de contact (20, 20'), et la languette de connexion (15) présente, pour le contact électrique, un côté de connexion (16) ayant une surface plate de connexion (16a),
en ce que
l'extrémité libre de la languette de connexion (15) présente une branche de flexion (15.2) qui est courbée vers le côté de connexion (16) d'un angle de compensation (α) par rapport au plan (A), la branche de flexion (15.2) qui présente la surface de connexion (16a) et la languette de connexion (15) étant conçue de manière à être flexible, **caractérisé**
**en ce que**, lorsqu'un partenaire de contact plat (20, 20'), soumis à une force provenant du côté de connexion (16), entre en contact avec l'extrémité libre de la branche de flexion (15.2), une orientation de position de la surface de connexion (16a) est apte à être adaptée à l'encontre de l'angle de compensation (α) jusqu'à un appui sans espace de la surface de connexion (16a) sur le partenaire de contact plat (20, 20').

2. Composant électrique et/ou électronique (10) selon la revendication 1,
**caractérisé en ce que**
l'angle de compensation (α) a une valeur comprise entre 0,5° et 5°, de préférence entre 0,5° et 1,5°.

3. Composant électrique et/ou électronique (10) selon la revendication 1 ou la revendication 2,
**caractérisé en ce que**
la languette de connexion (15) présente une branche de connexion (15.1), en particulier une branche de connexion droite (15.1), qui débouche par l'une de ses extrémités dans la branche de flexion (15.2) par l'intermédiaire d'un point de flexion (B) et comprend à son autre extrémité une connexion unilatérale de la languette de connexion (15) à l'intérieur du composant électrique et/ou électronique (10).

4. Composant électrique et/ou électronique (10) selon la revendication 3,
**caractérisé en ce que**
une extension longitudinale de la branche de connexion (15.1) est plusieurs fois plus courte qu'une extension longitudinale de la branche de flexion (15.2), en particulier de 2 à 20 fois plus courte, de préférence de 5 à 10 fois plus courte.

5. Composant électrique et/ou électronique (10) selon l'une des revendications précédentes,
**caractérisé en ce que**
le composant électrique et/ou électronique (10) présente un boîtier (12), d'un côté duquel la languette de connexion (15) fait saillie.

6. Composant électrique et/ou électronique (10) selon l'une des revendications précédentes,
**caractérisé en ce que**
le composant électrique et/ou électronique (10) présente un côté de connexion et/ou d'appui (12a) par rapport à un substrat de support (30), la languette de connexion (15) étant agencée à distance du côté de connexion et/ou d'appui (12a) et, dans une vue de dessus du côté de connexion ou d'appui (12a), fait saillie latéralement de celui-ci, à l'intérieur du composant électrique et/ou électronique (10) et est connectée d'un côté, la branche de flexion (15.2) étant orientée à l'opposé du côté de connexion et/ou d'appui (12a).

7. Composant électrique et/ou électronique (10) selon l'une des revendications précédentes,
**caractérisé en ce que**
le composant électrique et/ou électronique (10) est conçu sous la forme d'un module de puissance, notamment sous la forme d'un module de moule.

8. Agencement de contact (100), comprenant au moins un composant électrique et/ou électronique (10) selon l'une des revendications précédentes, dans lequel un contact de connexion (40), en particulier sans espace, est formé entre la languette de connexion (15) au niveau de la surface de connexion (16a) et un partenaire de contact plat (20, 20').

9. Agencement de contact (100) selon la revendication 8,
**caractérisé en ce que**
le contact de connexion (40) est conçu sous la forme d'un contact soudé, en particulier d'un contact soudé au laser.

10. Agencement de contact (100) selon l'une des revendications 8 ou 9,
**caractérisé en ce que**
l'agencement de contact (100) est réalisé en tant que partie d'un circuit électronique (35) sur un substrat de support (30), le partenaire de contact (20, 20') étant un clip de connexion qui relie par pontage la languette de connexion (15) et un point de connexion (36) du circuit électronique (35).

11. Agencement de contact (100) selon la revendication 10,
**caractérisé en ce que**
le circuit électronique est conçu sous la forme d'un pont B2 ou B6 (120), notamment en tant que partie de circuit d'un inverseur (110).

12. Procédé de réalisation d'un dispositif de contact (100) selon l'une des revendications 8 à 11, comprenant les étapes suivantes :
a) fourniture d'un composant électrique et/ou électronique (10) selon l'une des revendications 1 à 7, par exemple en le disposant sur un substrat support (30) par sa face inférieure de connexion et/ou d'appui (12a),
b) réalisation d'un agencement de sortie (100'), en disposant une face d'appui plate (20a) d'un partenaire de contact (20, 20') sur la face de connexion (16) de la languette de connexion (15) en contact d'appui avec l'extrémité exposée de la branche de flexion (15.2) et en posant un masque de soudage (80) sur une face de soudage (20b) opposée à la face d'appui (20a) du partenaire de contact (20, 20'),
c) application d'une force sur l'agencement de sortie (100') par une force d'enfoncement (F), en particulier au moyen d'un mouvement relatif (R), de préférence rectiligne, du masque de soudage (80), de telle sorte que, par un fléchissement de la languette de connexion (15) dans la direction de la force, il se produit une orientation de position modifiée de la surface de connexion (16a) à l'encontre de l'angle de compensation (α) de la branche de flexion (15.2),
d) maintien d'une position de soudage dans laquelle la surface de connexion (16a) de la languette de connexion (15) et le côté d'appui (20a) du partenaire de contact (20, 20') reposent à plat l'un contre l'autre,
e) formation d'un contact soudé (40), par exemple au moyen d'un laser sur la face soudée (20b) du partenaire de contact (20, 20'), en tant que contact de connexion (40) sans espace entre la languette de connexion (15) et le partenaire de contact (20, 20').

13. Procédé selon la revendication 12,
**caractérisé en ce que**
le partenaire de contact (20) est réalisé sous forme de clip de connexion (20'), une extrémité du clip de connexion (20') distante du contact d'appui étant maintenue immobile avant ou pendant l'étape b) du procédé, par exemple au moyen d'un outil de maintien (70) ou d'une liaison au moins indirecte par matière ou par force et/ou par complémentarité de forme avec le substrat de support (30).

14. Procédé selon la revendication 13,
**caractérisé en ce que**
entre l'extrémité maintenue fixe du clip de connexion (20') et le contact de connexion (40) à former ou formé avec la languette de connexion (15), un autre contact de connexion (40) est formé entre le clip de connexion (20') et un point de connexion (36) d'un circuit électronique (35), notamment sous forme de contact soudé.

15. Procédé selon la revendication 14,
**caractérisé en ce que**
l'autre contact de connexion (40) est formé avant, après ou en même temps que le contact de connexion (40) entre le clip de connexion (20, 20') et la languette de connexion (15).
